# EUROPEAN PATENT APPLICATION

(11) **EP 2 624 675 A1**
(43) Date of publication of application: **07.08.2013**
(21) Application number: 11833780.7
(22) Date of filing: 01.08.2011
(51) Int. Cl.: H05K 7/18

(54) **MOUNTING SUPPORT FRAME**

(30) Priority: 22.10.2010 CN 201010532666
(71) Applicant: Huawei Technologies Co., Ltd., Shenzhen, Guangdong 518129 (CN)
(72) Inventor: REN, Jianguang, Guangdong 518129 (CN); LI, Shijie, Guangdong 518129 (CN); HUANG, Jichang, Guangdong 518129 (CN); LONG, Jinsong, Guangdong 518129 (CN)
(74) Representative: Körber, Martin Hans
(86) International application number: PCT/CN2011/077867
(87) International publication number: WO 2012/051874

(57) **Abstract**

A mounting bracket is provided, which is configured to adapt to the mounting manners of various telecommunication devices. The mounting bracket includes: a guide rail 1 and a guide rail 2 which are parallel to a first direction, and a guide rail 3 and a guide rail 4 which are parallel to a second direction, where each of the guide rail 1, the guide rail 2, the guide rail 3, and the guide rail 4 is disposed with a C-shaped guide rail; two ends of each of the guide rail 3 and the guide rail 4 may move at the first direction along the C-shaped guide rail of the guide rail 1 and the C-shaped guide rail of the guide rail 2, and are fixed, through a guide rail fastening structure, to the guide rail 1 and the guide rail 2; the C-shaped guide rail of the guide rail 3 and the C-shaped guide rail of the guide rail 4 each are loaded with at least one device fastening structure for fixing a device, and the device fastening structure may move at the second direction along the C-shaped guide rail of the guide rail 3 or the C-shaped guide rail of the guide rail 4. The mounting bracket provided by the embodiments of the present invention may adapt to the sizes of various telecommunication devices and has the universality.

## Description

This application claims priority to Chinese Patent Application No. 201010532666.3, filed with the Chinese Patent Office on October 22, 2010 and entitled "MOUNTING BRACKET", which is incorporated herein by reference in its entirety.

### FIELD OF THE INVENTION

The present invention relates to the field of mechanical technologies, and in particular, to a mounting bracket.

### BACKGROUND OF THE INVENTION

With the development of the telecommunication technologies, the types of the telecommunication devices applied by the telecommunication operators are more and more, such as a switch, a router, a gateway, a repeater, and a converter. For ease of managing various telecommunication devices, a telecommunication operator often intends to centrally mount various telecommunication devices, and therefore a high requirement for a bracket for mounting various telecommunication devices is put forward, the bracket is required to be so flexible that the bracket can adapt to sizes (mainly length and width) of various telecommunication devices.

However, the inventor finds in practice that, at present, mounting brackets of various telecommunication devices are customized with specific telecommunication devices, and only adapt to the sizes of the specific telecommunication devices, but cannot adapt to the sizes of other telecommunication devices, and do not have the universality.

### SUMMARY OF THE INVENTION

Embodiments of the present invention provide a mounting bracket which is capable of adapting to sizes of various telecommunication devices and has universality.

An mounting bracket includes:
a guide rail 1 and a guide rail 2 which are parallel to a first direction, and a guide rail 3 and a guide rail 4 which are parallel to a second direction, in which each of the guide rail 1, the guide rail 2, the guide rail 3, and the guide rail 4 is disposed with a C-shaped guide rail;
two ends of each of the guide rail 3 and the guide rail 4 may move at the first direction along the C-shaped guide rail of the guide rail 1 and the C-shaped guide rail of the guide rail 2, and are fixed, through a guide rail fastening structure, to the guide rail 1 and the guide rail 2; and
the C-shaped guide rail of the guide rail 3 and the C-shaped guide rail of the guide rail 4 each is loaded with at least one device fastening structure for fixing a device, and the device fastening structure may move at the second direction along the C-shaped guide rail of the guide rail 3 or the C-shaped guide rail of the guide rail 4.

Compared with the prior art, the embodiments of the present invention have the following beneficial effects.

In the embodiments of the present invention, the guide rail 3 and the guide rail 4 of the mounting bracket may move back and forth along the C-shaped guide rail of the guide rail 1 and the C-shaped guide rail of the guide rail 2 which are parallel to each other, and at least one assembling bolt that is for fixing a telecommunication device and is loaded on the C-shaped guide rail of the guide rail 3 may move left and right along the C-shaped guide rail of the guide rail 3, at least one assembling bolt that is for fixing the telecommunication device and is loaded on the C-shaped guide rail of the guide rail 4 may move left and right along the C-shaped guide rail of the guide rail 4. In this way, by adjusting the guide rail 3 and/or the guide rail 4 to move back and forth along the C-shaped guide rail of the guide rail 1 and the C-shaped guide rail of the guide rail 2, the lengths of various telecommunication devices may be adapted. By adjusting the at least one assembling bolt that is for fixing the telecommunication device and is loaded on the C-shaped guide rail of the guide rail 3 and the at least one assembling bolt that is for fixing the telecommunication device and is loaded on the C-shaped guide rail of the guide rail 4 to move right and left, the widths of various telecommunication devices may be adapted. The mounting bracket provided in the embodiments of the present invention may adapt to the sizes of various telecommunication devices and has the universality.

### BRIEF DESCRIPTION OF THE DRAWINGS

To illustrate the technical solutions according to the embodiments of the present invention more clearly, the accompanying drawings for describing the embodiments are introduced briefly in the following. Apparently, the accompanying drawings in the following description are only about some embodiments of the present invention, and persons of ordinary skill in the art can derive other drawings from the accompanying drawings without creative efforts.

FIG. 1 is a schematic structural diagram of a mounting bracket according to an embodiment of the present invention;

FIG. 2 is a schematic diagram of a connection manner of one end of a guide rail 3 and a guide rail 1 according to an embodiment of the present invention;

FIG. 3 is a schematic diagram of another connection manner of one end of the guide rail 3 and the guide rail 1 according to an embodiment of the present invention;

FIG. 4 is a schematic diagram of another connection manner of one end of the guide rail 3 and the guide rail 1 according to an embodiment of the present invention;

FIG. 5 is a schematic diagram of another connection manner of one end of the guide rail 3 and the guide rail 1 according to an embodiment of the present invention;

FIG. 6 is a schematic diagram of loading an assembling bolt on a C-shaped guide rail of the guide rail 3 according to an embodiment of the present invention;

FIG. 7 is another schematic diagram of loading an assembling bolt on a C-shaped guide rail of the guide rail 3 according to an embodiment of the present invention;

FIG. 8 is a schematic structural diagram of a seat frame according to an embodiment of the present invention; and

FIG. 9 is a schematic structural diagram of a support lever according to an embodiment of the present invention.

### DETAILED DESCRIPTION OF THE EMBODIMENTS

The technical solutions of the present invention will be clearly and completely described in the following with reference to the accompanying drawings. It is obvious that the embodiments to be described are only a part rather than all of the embodiments of the present invention. All other embodiments obtained by persons of ordinary skill in the art based on the embodiments of the present invention without creative efforts shall fall within the protection scope of the present invention.

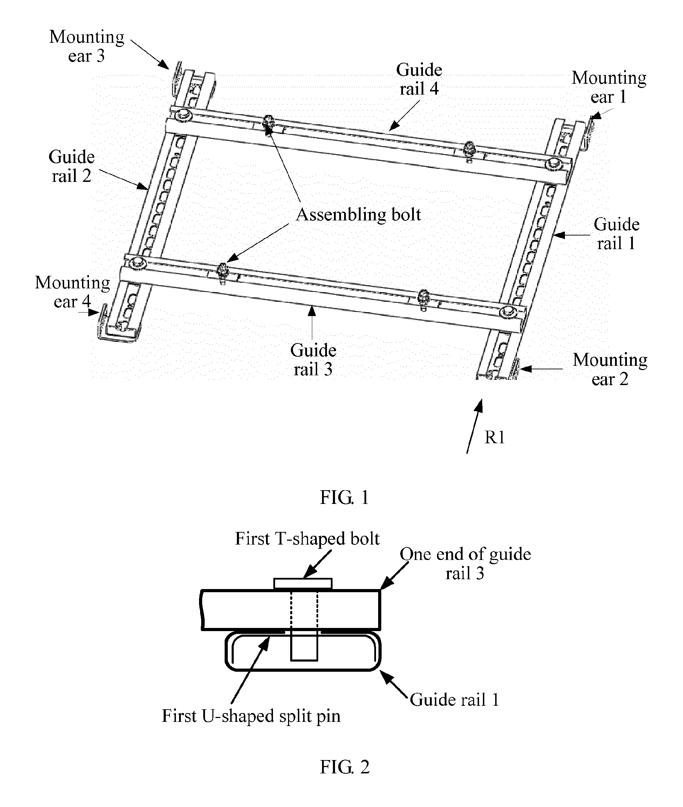

Referring to FIG. 1, FIG. 1 is a schematic structural diagram of a mounting bracket according to an embodiment of the present invention. As shown in FIG. 1, the mounting bracket may include:

a guide rail 1 and a guide rail 2 which are parallel to a first direction, and a guide rail 3 and a guide rail 4 which are parallel to a second direction, where each of the guide rail 1, the guide rail 2, the guide rail 3, and the guide rail 4 is disposed with a C-shaped guide rail.

Two ends of each of the guide rail 3 and the guide rail 4 may move at the first direction along the C-shaped guide rail of the guide rail 1 and the C-shaped guide rail of the guide rail 2, and are fixed, through a guide rail fastening structure, to the guide rail 1 and the guide rail 2.

The C-shaped guide rail of the guide rail 3 and the C-shaped guide rail of the guide rail 4 each is loaded with at least one device fastening structure for fixing a device, and the device fastening structure may move at the second direction along the C-shaped guide rail of the guide rail 3 or the C-shaped guide rail of the guide rail 4.

The first direction may be perpendicular to the second direction; the pointing direction of the opening of the C-shaped guide rail of each guide rail is the same (all upward as shown in the figure). The C-shape herein is a shape similar to " 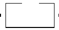 ".

The guide rail fastening structure includes a T-shaped bolt and a U-shaped split pin; at least one end of the guide rail 3 and at least one end of the guide rail 4 are fixed with the guide rail 1 or the guide rail 2 through the T-shaped bolt and the U-shaped split pin. The U-shaped split pin is inverted inside the C-shaped guide rail of a lower layer guide rail, the T-shaped bolt passes through a first U-shaped split pin, and is tightly pressed, through a screw cap of the T-shaped bolt, with an external surface at the opening side of the C-shaped guide rail of an upper layer guide rail, or is tightly pressed with the internal bottom surface of the C-shaped guide rail of an upper layer guide rail. The external surface of the first U-shaped split pin is tightly pressed with an internal surface at the opening side of the C-shaped guide rail of the lower layer guide rail. The upper layer guide rail is the guide rail 3 or the guide rail 4, and the lower layer guide rail is the corresponding guide rail 1 or guide rail 2 connected by the upper layer guide rail through the guide rail fastening structure.

Alternatively, the guide rail fastening structure includes a T-shaped bolt and a square nut. At least one end of the guide rail 3 and at least one end of the guide rail 4, through the T-shaped bolt and the square nut, are fixed with the guide rail 1 or the guide rail 2. The T-shaped bolt passes through the square nut to tightly press one end of the upper layer guide rail to the lower layer guide rail. The square nut is tightly pressed with the external bottom surface of the upper layer guide rail. The screw cap of the T-shaped bolt is tightly pressed with the external surface at the opening side of the C-shaped guide rail of the upper layer guide rail, or is tightly pressed with the internal bottom surface of the C-shaped guide rail of the upper layer guide rail.

The device fastening structure may be an assembling bolt.

Specifically, referring to FIG. 1, an embodiment of the present invention includes: the guide rail 1, the guide rail 2, the guide rail 3, and the guide rail 4 whose cross sections are in the C-shape.

The guide rail 1 is parallel to the guide rail 2, and the guide rail 3 is parallel to the guide rail 4; two ends of the guide rail 3 are connected to the guide rail 1 and the guide rail 2, and two ends of the guide rail 4 are connected to the guide rail 1 and the guide rail 2.

As shown in FIG. 1, the guide rail 3 is perpendicular to the guide rail 1 and the guide rail 2, and the guide rail 4 is perpendicular to the guide rail 1 and the guide rail 2. Alternatively, in this embodiment, sizes of the guide rail 1, the guide rail 2, the guide rail 3, and the guide rail 4 are completely the same.

Two ends of the guide rail 3 and two ends of the guide rail 4 may move along the C-shaped guide rail of the guide rail 1 and the C-shaped guide rail of the guide rail 2.

The C-shaped guide rail of the guide rail 3 is loaded with at least one assembling bolt for fixing a device (a telecommunication device is taken as example for illustration in the following), and the assembling bolt may move along the C-shaped guide rail of the guide rail 3.

The C-shaped guide rail of the guide rail 4 is loaded with at least one assembling bolt for fixing the telecommunication device, and the assembling bolt may move left and right along the C-shaped guide rail of the guide rail 4.

The pointing directions of the openings of the C-shaped guide rails of the guide rail 1, the guide rail 2, the guide rail 3, and the guide rail 4 are the same (all upward as shown in FIG. 1), that is, the openings of the C-shaped guide rails of the guide rail 1, the guide rail 2, the guide rail 3, and the guide rail 4 all point to a side where the telecommunication device is mounted.

The mounting bracket as shown in FIG. 1 may also include mounting ears 1 to 4.

One side of the mounting ear 1 is fixedly connected to one end of the guide rail 1, and one side of the mounting ear 2 is fixedly connected to the other end of the guide rail 1; one side of the mounting ear 3 is fixedly connected to one end of the guide rail 2, and one side of the mounting ear 4 is fixedly connected to the other end of the guide rail 2.

The other side of each of the mounting ears 1 to 4 may be fixedly connected to a fixture (such as a seat frame, and a wall), so that the mounting bracket may be fixed, through the mounting ears, to the fixture.

In the embodiment of the present invention, adjusting the guide rail 3 and/or the guide rail 4 to move back and forth along the C-shaped guide rail of the guide rail 1 and the C-shaped guide rail of the guide rail 2 which are parallel to each other may adapt to the lengths of various telecommunication devices; adjusting the at least one assembling bolt that is for fixing the telecommunication device and is loaded on the C-shaped guide rail of the guide rail 3 and the at least one assembling bolt that is for fixing the telecommunication device and is loaded on the C-shaped guide rail of the guide rail 4 may adapt to the widths of various telecommunication devices; and the mounting bracket provided in the embodiment of the present invention may be used as a base for mounting various telecommunication devices and is capable of adapting to the heights of various telecommunication devices, so as to adapt to the sizes of various telecommunication devices, and the mounting bracket has the universality.

Referring to FIG. 2, FIG. 2 is a schematic diagram of a connection manner of one end of the guide rail 3 and the guide rail 1 (viewed laterally from the direction of an arrow R1 in FIG. 1) according to an embodiment of the present invention.

As shown in FIG. 2, one end of the guide rail 3 is connected to the guide rail 1 through a first T-shaped bolt and a first U-shaped split pin. The first U-shaped split pin is inverted inside the C-shaped guide rail of the guide rail 1, and the first T-shaped bolt passes through the first U-shaped split pin to tightly press one end of the guide rail 3 to the guide rail 1. Specifically, the screw cap of the first T-shaped bolt is tightly pressed with the external surface at the opening side of the C-shaped guide rail of the guide rail 3, and the external surface of the first U-shaped split pin is tightly pressed with the internal surface at the opening side of the C-shaped guide rail of the guide rail 1.

In the embodiment of the present invention, the first U-shaped split pin has a certain thickness, and the first T-shaped bolt (with a thread on a surface) rotationally passes through the first U-shaped split pin through a threaded hole (not drawn in FIG. 2) of the first U-shaped split pin. In addition, the width of the first U-shaped split pin should be close to the width of the C-shaped guide rail of the guide rail 1 as much as possible, so that when the first T-shaped bolt rotationally passes through the threaded hole of the first U-shaped split pin, because the left side and the right side of the first U-shaped split pin contradict the C-shaped guide rail, the first U-shaped split pin does not rotate as the first T-shaped bolt is rotated, thereby implementing the positioning of the first T-shaped bolt on the C-shaped guide rail of the guide rail 1.

Accordingly, the other end of the guide rail 3 may also be connected to the guide rail 2 through the connection manner as shown in FIG. 2. The other end of the guide rail 3 is connected to the guide rail 2 through a second T-shaped bolt and a second U-shaped split pin. The second U-shaped split pin is inverted inside the C-shaped guide rail of the guide rail 2, and the second T-shaped bolt passes through the second U-shaped split pin to tightly press the other end of the guide rail 3 to the guide rail 2. Specifically, the screw cap of the second T-shaped bolt is tightly pressed with the external surface at the opening side of the C-shaped guide rail of the guide rail 3. The external surface of the second U-shaped split pin is tightly pressed with the internal surface at the opening side of the C-shaped guide rail of the guide rail 2.

In the embodiment of the present invention, the structure of the second T-shaped bolt is the same as the structure of the first T-shaped bolt, and the structure of the second U-shaped split pin is the same as the structure of the first U-shaped split pin. When the second T-shaped bolt rotationally passes through the threaded hole of the second U-shaped split pin, because the left side and the right side of the second U-shaped split pin contradict the C-shaped guide rail, the second U-shaped split pin does not rotate as the second T-shaped bolt is rotated, thereby implementing the positioning of the second T-shaped bolt on the C-shaped guide rail of the guide rail 2.

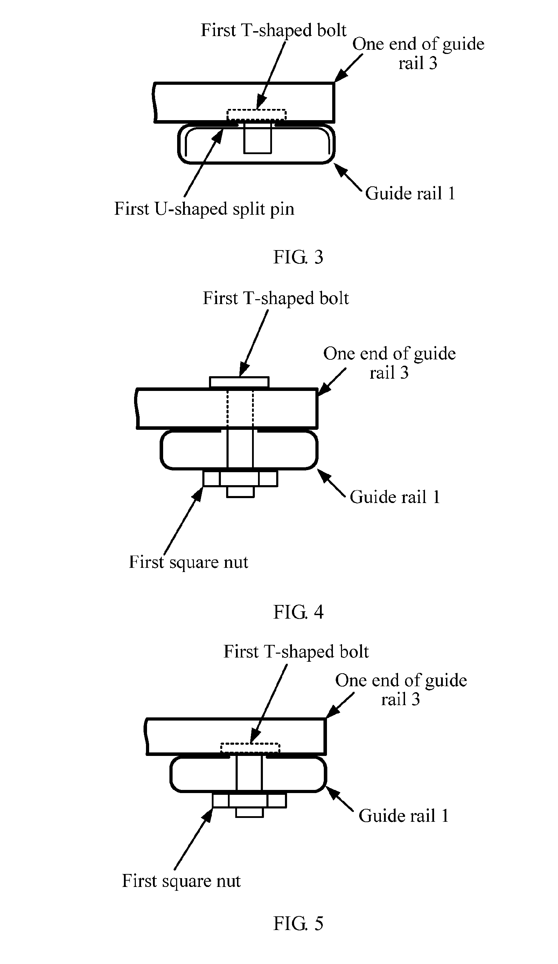

Referring to FIG. 3, FIG. 3 is a schematic diagram of another connection manner of one end of the guide rail 3 and the guide rail 1 according to an embodiment of the present invention.

As shown in FIG. 3, the screw cap of the first T-shaped bolt is tightly pressed with the internal bottom surface of the C-shaped guide rail of the guide rail 3, and the external surface of the first U-shaped split pin is tightly pressed with the internal surface at the opening side of the C-shaped guide rail of the guide rail 1, so as to tightly press one end of the guide rail 3 to the guide rail 1.

In the embodiment of the present invention, a schematic diagram of another connection manner of the other end of the guide rail 3 and the guide rail 2 may be similar to FIG. 3. Specifically, the screw cap of the second T-shaped bolt is tightly pressed with the external surface at the opening side of the C-shaped guide rail of the guide rail 3. The external surface of the second U-shaped split pin is tightly pressed with the internal surface at the opening side of the C-shaped guide rail of the guide rail 2, so as to tightly press the other end of the guide rail 3 to the guide rail 2.

In the embodiment of the present invention, the connection manner of the guide rail 4 and the guide rail 2 may be the same as those in FIG. 2 and FIG. 3.

Referring to FIG. 4, FIG. 4 is a schematic diagram of still another connection manner of one end of the guide rail 3 and the guide rail 1 according to an embodiment of the present invention.

As shown in FIG. 4, one end of the guide rail 3 is connected to the guide rail 1 through a first T-shaped bolt and a first square nut. The first T-shaped bolt passes through the first square nut to tightly press one end of the guide rail 3 to the guide rail 1. Specifically, the first square nut is tightly pressed with the external bottom surface of the guide rail 1, and the screw cap of the first T-shaped bolt is tightly pressed with the external surface at the opening side of the C-shaped guide rail of the guide rail 3, so as to tightly press one end of the guide rail 3 to the guide rail 1.

Accordingly, the other end of the guide rail 3 may also be connected to the guide rail 2 through the connection manner as shown in FIG. 4. The other end of the guide rail 3 is connected to the guide rail 2 through a second T-shaped bolt and a second square nut. Specifically, the second T-shaped bolt passes through the second square nut to tightly press the other end of the guide rail 3 to the guide rail 2. The second square nut is tightly pressed with the external bottom surface of the guide rail 2, and the screw cap of the second T-shaped bolt is tightly pressed with the external surface at the opening side of the C-shaped guide rail of the guide rail 3, so as to to tightly press one end of the guide rail 3 to the guide rail 1.

Referring to FIG. 5, FIG. 5 is a schematic diagram of yet another connection manner of one end of the guide rail 3 and the guide rail 1 according to an embodiment of the present invention;

As shown in FIG. 5, one end of the guide rail 3 is connected to the guide rail 1 through the first T-shaped bolt and the first square nut. The first T-shaped bolt passes through the first square nut to tightly press one end of the guide rail 3 to the guide rail 1. Specifically, the first square nut is tightly pressed with the external bottom surface of the guide rail 1, and the screw cap of the first T-shaped bolt is tightly pressed with the internal bottom surface of the C-shaped guide rail of the guide rail 3, so as to tightly press one end of the guide rail 3 to the guide rail 1.

Accordingly, the other end of the guide rail 3 may also be connected to the guide rail 2 through the connection manner as shown in FIG. 5. The other end of the guide rail 3 is connected to the guide rail 2 through the second T-shaped bolt and the second square nut. Specifically, the second T-shaped bolt passes through the second square nut to tightly press the other end of the guide rail 3 to the guide rail 2. The second square nut is tightly pressed with the external bottom surface of the guide rail 2, and the screw cap of the second T-shaped bolt is tightly pressed with the internal bottom surface of the C-shaped guide rail of the guide rail 3, so as to tightly press the other end of the guide rail 3 to the guide rail 2.

In the embodiment of the present invention, the connection manner of the guide rail 4 and the guide rail 2 may be the same as those in FIG. 4 and FIG. 5.

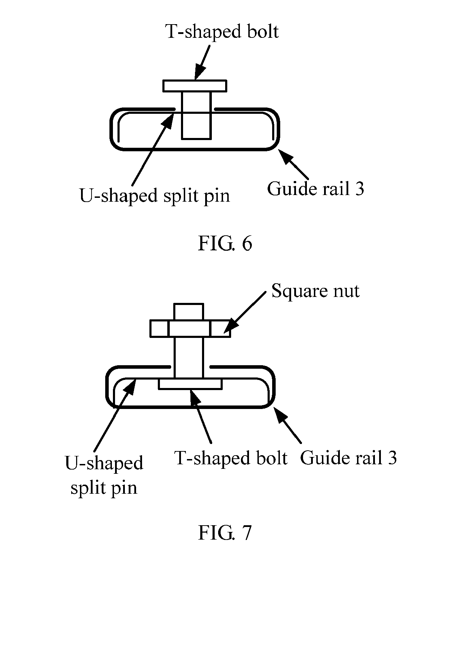

Referring to FIG. 6, FIG. 6 is a schematic diagram of loading an assembling bolt that is for fixing a device and is on the C-shaped guide rail of the guide rail 3 according to an embodiment of the present invention.

As shown in FIG. 6, the assembling bolt that is for fixing a telecommunication device and is loaded on the C-shaped guide rail of the guide rail 3 is formed by a T-shaped bolt and a U-shaped split pin. The U-shaped split pin is inverted inside the C-shaped guide rail of the guide rail 3, the T-shaped bolt passes through the U-shaped split pin, and when the T-shaped bolt is rotated to an appropriate position, the external surface of the U-shaped split pin is tightly pressed with the internal surface at the opening side of the C-shaped guide rail of the guide rail 3.

Accordingly, the schematic diagram of loading the assembling bolt that is for fixing the telecommunication device and is on the C-shaped guide rail of the guide rail 4 may be the same as FIG. 6.

That is, the assembling bolt that is for fixing the telecommunication device and is loaded on the C-shaped guide rail of the guide rail 4 is formed by a T-shaped bolt and a U-shaped split pin. The U-shaped split pin is inverted inside the C-shaped guide rail of the guide rail 4, the T-shaped bolt passes through the U-shaped split pin, and when the T-shaped bolt is rotated to an appropriate position, the external surface of the U-shaped split pin is tightly pressed with the internal surface at the opening side of the C-shaped guide rail of the guide rail 4.

When the telecommunication device is mounted, first the assembling bolt of the C-shaped guide rail of the guide rail 3 and the assembling bolt of the C-shaped guide rail of the guide rail 4 are adjusted to move left and right to adapt to the width of the telecommunication device, and then the T-shaped bolt of the assembling bolt of the C-shaped guide rail of the guide rail 3 and the T-shaped bolt of the assembling bolt of the C-shaped guide rail of the guide rail 4 are separately rotated until the screw caps of the T-shaped bolts are tightly pressed with the connection surface of the telecommunication device, the external surface of the U-shaped split pin inverted inside the C-shaped guide rail of the guide rail 3 is tightly pressed with the internal surface at the opening side of the C-shaped guide rail, and the external surface of the U-shaped split pin inverted inside the C-shaped guide rail of the guide rail 4 is tightly pressed with the internal surface at the opening side of the C-shaped guide rail, so as to fixedly mount the telecommunication device.

Referring to FIG. 7, FIG. 7 is another schematic diagram of loading an assembling bolt that is for fixing a telecommunication device and is on the C-shaped guide rail of the guide rail 3 according to an embodiment of the present invention.

As shown in FIG. 7, the assembling bolt that is for fixing the telecommunication device and is loaded on the C-shaped guide rail of the guide rail 3 is formed by a T-shaped bolt, a U-shaped split pin, and a square nut. The U-shaped split pin is inverted inside the C-shaped guide rail of the guide rail 3, the T-shaped bolt passes through the U-shaped split pin and extends out from the opening of the C-shaped guide rail of the guide rail 3, and the screw cap of the T-shaped bolt is fixedly connected to the internal surface of the U-shaped split pin. The square nut may be rotated up and down along the T-shaped bolt that extends out, and when the square nut is rotated to an appropriate position, the external surface of the U-shaped split pin is tightly pressed with the internal surface at the opening side of the C-shaped guide rail of the guide rail 3.

It should be noted that, FIG. 7 is a schematic diagram of an intermediate state in a fixing process, and as the nut is rotated along the T-shaped bolt, the U-shaped split pin and the opening side of the guide rail 3 are tightly pressed with each other.

Accordingly, the schematic diagram of loading the assembling bolt that is for fixing the telecommunication device and is on the C-shaped guide rail of the guide rail 4 may be the same as FIG. 7.

In the embodiment of the present invention, when the C-shaped guide rail of the guide rail 3, and the C-shaped guide rail of the guide rail 4 are loaded with the assembling bolts in the manner shown in FIG. 7, if the T-shaped bolt is long enough, the mounting of various telecommunication devices whose connection surfaces have different thicknesses may be compatible.

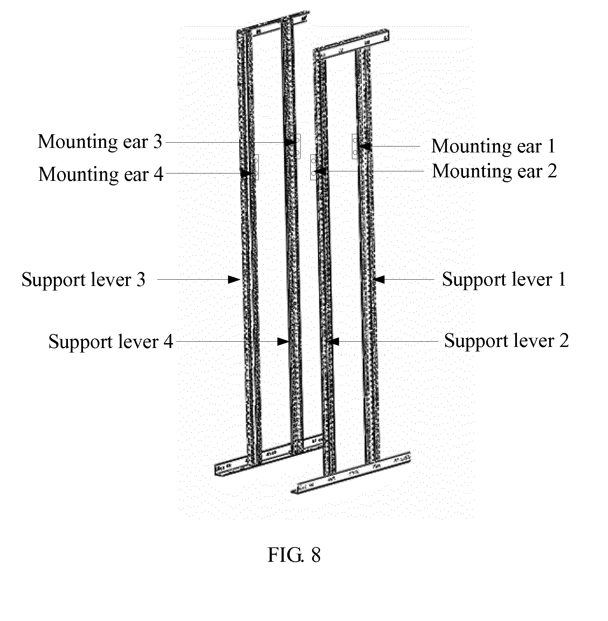

Referring to FIG. 8, FIG. 8 is a three-dimensional seat frame for fixing the mounting bracket according to an embodiment of the present invention.

As shown in FIG. 8, support levers 1 to 4 with the same structure in the three-dimensional seat frame are perpendicular to the ground; the support lever 1 is fixedly connected to the other side of the mounting ear 1, the support lever 2 is fixedly connected to the other side of the mounting ear 2, the support lever 3 is fixedly connected to the other side of the mounting ear 3, and the support lever 4 is fixedly connected to the other side of the mounting ear 4, so that the guide rail 1 and the guide rail 2 are fixed in parallel to the ground, that is, the mounting bracket may be parallelly fixed on the three-dimensional seat frame.

As shown in FIG. 8, the three-dimensional seat frame also includes several connecting rods, and the connecting rods are configured to fix the support levers 1 to 4, so that the support levers 1 to 4 may be perpendicular to the ground.

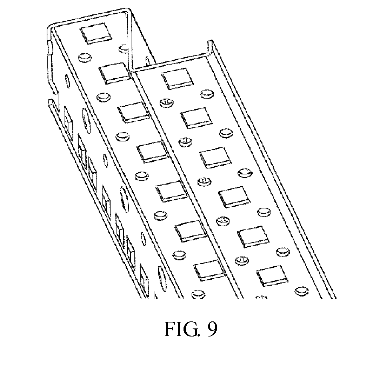

In this embodiment, in the three-dimensional bracket, each support lever is formed by two "["-shaped slots, the two "["-shaped slots of each support lever are opposite in direction and share a connection surface. Each "["-shaped slot is distributed with duplicate holes according to the modulus along a length direction, and as shown in FIG. 9, the duplicate holes are used to fix the guide rail 1 and the guide rail 2 in parallel to the ground in cooperation with the mounting ears.

A mounting bracket provided in the embodiments of the present invention is introduced in detail above, and the telecommunication device is taken as an example for illustration in the embodiments of the present invention. Actually, the embodiments of the present invention are not merely limited to the telecommunication device, and other indoor devices or outdoor devices may be mounted and fixed through the embodiments of the present invention. The principle and implementation of the present invention are described herein through specific examples. The description about the embodiments of the present invention is merely provided for ease of understanding of the method and the core idea of the present invention. Persons of ordinary skill in the art can make variations and modifications to the present invention in terms of the specific implementation and the application scope according to the idea of the present invention. Therefore, the content of the specification shall not be construed as a limit to the present invention.

## Claims

1. A mounting bracket, comprising:
a guide rail 1 and a guide rail 2 which are parallel to a first direction, and a guide rail 3 and a guide rail 4 which are parallel to a second direction, wherein each of the guide rail 1, the guide rail 2 and the guide rail 3, and the guide rail 4 is disposed with a C-shaped guide rail;
two ends of each of the guide rail 3 and the guide rail 4 are capable of moving at the first direction along the C-shaped guide rail of the guide rail 1 and the C-shaped guide rail of the guide rail 2, and are fixed, through a guide rail fastening structure, to the guide rail 1 and the guide rail 2; and
the C-shaped guide rail of the guide rail 3 and the C-shaped guide rail of the guide rail 4 each are loaded with at least one device fastening structure that is for fixing a device, and the device fastening structure is capable of moving at the second direction along the C-shaped guide rail of the guide rail 3 or the C-shaped guide rail of the guide rail 4.

2. The mounting bracket according to claim 1, wherein the first direction is perpendicular to the second direction.

3. The mounting bracket according to claim 1, wherein a pointing direction of an opening of the C-shaped guide rail of the guide rail 1, a pointing direction of an opening of the C-shaped guide rail of the guide rail 2, a pointing direction of an opening of the C-shaped guide rail of the guide rail 3, and a pointing direction of an opening of the C-shaped guide rail of the guide rail 4 are the same.

4. The mounting bracket according to claim 1, wherein:
the guide rail fastening structure comprises a T-shaped bolt and a U-shaped split pin; at least one end of the guide rail 3 and at least one end of the guide rail 4 are fixed with the guide rail 1 or the guide rail 2 through the T-shaped bolt and the U-shaped split pin.

5. The mounting bracket according to claim 4, wherein the U-shaped split pin is inverted inside a C-shaped guide rail of a lower layer guide rail, the T-shaped bolt passes through a first U-shaped split pin and, through a screw cap of the T-shaped bolt, is tightly pressed with an external surface at an opening side of a C-shaped guide rail of an upper layer guide rail or is tightly pressed with an internal bottom surface of a C-shaped guide rail of an upper layer guide rail; an external surface of the first U-shaped split pin is tightly pressed with an internal surface at an opening side of the C-shaped guide rail of the lower layer guide rail;
the upper layer guide rail is the guide rail 3 or the guide rail 4, and the lower layer guide rail is the corresponding guide rail 1 or guide rail 2 connected by the upper layer guide rail through the guide rail fastening structure.

6. The mounting bracket according to claim 1, wherein the fastening structure comprises a T-shaped bolt and a square nut; at least one end of the guide rail 3 and at least one end of the guide rail 4 are fixed, through the T-shaped bolt and the square nut, to the guide rail 1 or the guide rail 2.

7. The mounting bracket according to claim 6, wherein the T-shaped bolt passes through the square nut to tightly press one end of an upper layer guide rail to a lower layer guide rail; the square nut is tightly pressed with an external bottom surface of the upper layer guide rail; a screw cap of the T-shaped bolt is tightly pressed with an external surface at an opening side of a C-shaped guide rail of the upper layer guide rail, or is tightly pressed with an internal bottom surface of a C-shaped guide rail of an upper layer guide rail; and
the upper layer guide rail is the guide rail 3 or the guide rail 4, and the lower layer guide rail is the corresponding guide rail 1 or guide rail 2 connected by the upper layer guide rail through the guide rail fastening structure.

8. The mounting bracket according to claim 1, wherein the device fastening structure that is for fixing the device and is loaded on the C-shaped guide rail of the guide rail 3 or the C-shaped guide rail of the guide rail 4 is formed by a T-shaped bolt and a U-shaped split pin;
the U-shaped split pin is inverted inside the C-shaped guide rail of the guide rail 3 or the C-shaped guide rail of the guide rail 4, the T-shaped bolt passes through the U-shaped split pin, and when the T-shaped bolt is rotated to an appropriate position, an external surface of the U-shaped split pin is tightly pressed with an internal surface at an opening side of the C-shaped guide rail of the guide rail 3.

9. The mounting bracket according to claim 1, wherein the device fastening structure that is for fixing the device and is loaded on the C-shaped guide rail of the guide rail 3 or the C-shaped guide rail of the guide rail 4 is formed by a T-shaped bolt, a U-shaped split pin, and a square nut;
the U-shaped split pin is inverted inside the C-shaped guide rail of the guide rail 3 or the C-shaped guide rail of the guide rail 4, a screw cap of the T-shaped bolt is located inside the U-shaped split pin, the T-shaped bolt passes through the U-shaped split pin and extends out from an opening of the C-shaped guide rail of the guide rail 3 or the C-shaped guide rail of the guide rail 4, and the screw cap of the T-shaped bolt is fixedly connected to an internal surface of the U-shaped split pin; the square nut may be rotated up and down along the bolt that extends out, and when the square nut is rotated to an appropriate position, an external surface of the U-shaped split pin is tightly pressed with an internal surface at an opening side of the C-shaped guide rail of the guide rail 3 or the guide rail 4.

10. The mounting bracket according to any one of claims 1 to 9, further comprising multiple mounting ears, configured to mount the guide rail 1 and the guide rail 2 to a fixture.

11. The mounting bracket according to claim 10, further comprising a three-dimensional seat frame, wherein the three-dimensional seat frame is disposed with multiple support levers, the support levers are disposed with duplicate holes along a length direction, and the duplicate holes are used to fix the guide rail 1 and the guide rail 2 in parallel to the ground in cooperation with the mounting ears.
